# EUROPÄISCHE PATENTSCHRIFT

(11) **EP 3 120 430 B1**
(45) Veröffentlichungstag und Bekanntmachung des Hinweises auf die Patenterteilung: **11.04.2018**
(21) Anmeldenummer: 15702438.1
(22) Anmeldetag: 28.01.2015
(51) Int. Cl.: H02B 1/38, E05B 17/20, E05B 47/06, E05B 53/00, E05B 65/00, E05C 9/04, H01H 9/22

(54) **VERRIEGELUNGSVORRICHTUNG FÜR EINEN SCHALTSCHRANK**
LOCKING DEVICE FOR A SWITCHGEAR CABINET
DISPOSITIF DE VERROUILLAGE POUR UNE ARMOIRE DE COMMANDE

(30) Priorität: 21.03.2014 EP 14161088
(43) Veröffentlichungstag der Anmeldung: 25.01.2017
(73) Patentinhaber: ABB Schweiz AG, 5400 Baden (CH)
(72) Erfinder: KIPFER, Manfred, CH-8733 Eschenbach (CH)
(74) Vertreter: ABB Patent Attorneys
(86) Internationale Anmeldenummer: PCT/EP2015/051734
(87) Internationale Veröffentlichungsnummer: WO 2015/139866

(56) Entgegenhaltungen:
- DE-U1-202007 007 723
- DE-U1-202012 006 108

## Beschreibung

### GEBIET DER ERFINDUNG

Die Erfindung betrifft das Gebiet der Sicherheitstechnik von Mittel- und Hochspannungsanlagen. Insbesondere betrifft die Erfindung eine Verriegelungsvorrichtung für einen Schaltschrank. Die Erfindung betrifft auch einen Schaltschrank.

### HINTERGRUND DER ERFINDUNG

Aus Gründen der Betriebssicherheit und des Personenschutzes im Umgang mit Schaltschränken, die elektrische Anlagen enthalten, ist es normalerweise notwendig, diese während des Betriebs der elektrischen Anlage sicher zu verschließen.

Viele Schaltschränke weisen eine Mehrzahl von Türen auf. In diesem Fall sollten alle Türen verschlossen und verriegelt sein, wenn die elektrische Anlage in Betrieb ist.

Die DE 10 2007 051 511 B3 zeigt eine Schaltschrankanordnung mit einer Verriegelungseinrichtung, die beim Öffnen einer Haupttür eine oder mehrere Nebentüren entriegelt. Ein Hakenelement wird dabei von einer Schubstange angehoben und kann zum Verriegeln einer Türe schwerkraftbedingt in ein Winkelelement fallen, um die jeweilige Türe wieder zu verriegeln.

Auch die DE 20 2012 006 108 U1 zeigt eine ausfallsichere Mehrfach-Türverriegelung für einen Schaltschrank, bei der mehrere Türen gleichzeitig verriegelt werden können. Gemäss Fig. 1, Fig. 2 und Fig. 3 der DE 20 2012 006 108 U1 umfasst die Verriegelungsvorrichtung 100 einen Verriegelungsschieber 110, der zwischen einer entriegelten Stellung und einer verriegelten Stellung verschiebbar ist; ein mit dem Verriegelungsschieber 110 verbundenes erstes Sperrelement 130 und ein betätigbares zweites Sperrelement 120, das dazu ausgeführt ist, mit dem ersten Sperrelement 130 in der verriegelten Stellung des Verriegelungsschiebers 110 in Eingriff zu gehen. Für wenigstens zwei Türen 520 ist jeweils ein Türsicherungsschieber 530 vorgesehen, der entlang der jeweiligen Türe 520 zwischen einer entriegelten Stellung und einer verriegelten Stellung verschiebbar ist und der in einer geschlossenen Stellung der Türe 520 mit dem Verriegelungsschieber 110 gekoppelt ist, so dass der Verriegelungsschieber 110 und der Türsicherungsschieber 530 zusammen verschiebbar sind.

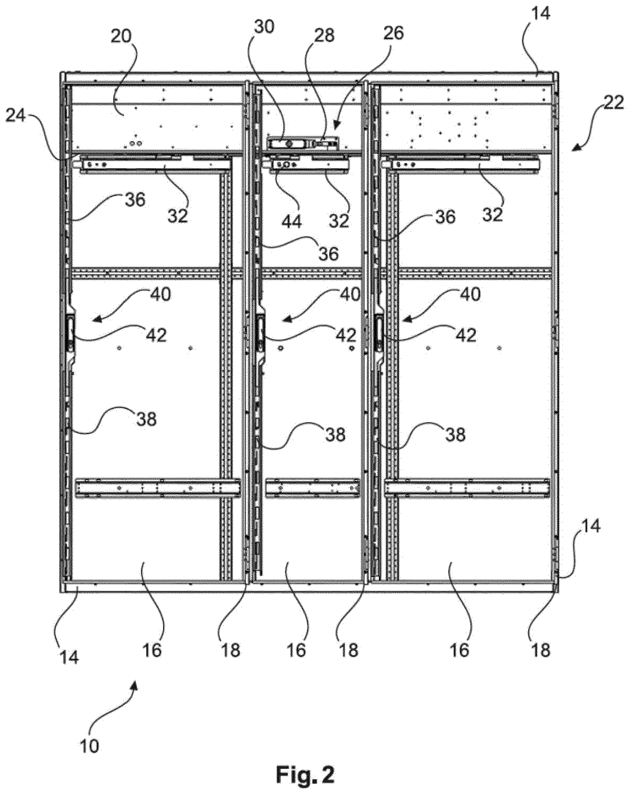

Ferner ist in der DE 20 2007 007723 U1 ist eine Sicherheitseinrichtung für einen Schwenkhebelstangenverschluss für eine einzige Schaltschranktüre angegeben, wobei in Fig. 2 die einzige Türe mit einer Verschlussstange 24 durch einen Stift 38 an der Verschiebung gehindert werden kann. Der Stift 38 wird durch einen Hubmagneten 26 betätigt.

### ZUSAMMENFASSUNG DER ERFINDUNG

Es ist Aufgabe der Erfindung, einen sicheren und einfach zu bedienenden Schaltschrank bereitzustellen.

Diese Aufgabe wird durch den Gegenstand des unabhängigen Anspruchs 1 gelöst. Weitere Ausführungsformen der Erfindung ergeben sich aus den abhängigen Ansprüchen und aus der folgenden Beschreibung.

Ein Aspekt der Erfindung betrifft eine Verriegelungsvorrichtung für einen Schaltschrank mit einer Mehrzahl von Türen. Der Schaltschrank kann eine elektrische Mittel- oder Hochspannungsanlage, wie beispielsweise Komponenten eines Umrichters, enthalten, die von den Türen sowie Abdeckplatten an den Seiten und an der Decke des Schaltschranks umschlossen ist. Die Türen können nebeneinander an einer Vorderseite des Schaltschranks angeordnet sein und beispielsweise um eine vertikale Achse geöffnet werden.

Gemäß einer Ausführungsform der Erfindung umfasst die Verriegelungsvorrichtung einen Verriegelungsschieber, der zwischen einer entriegelten Stellung und einer verriegelten Stellung verschiebbar ist, ein mit dem Verriegelungsschieber verbundenes erstes Sperrelement und ein elektrisch betätigbares zweites Sperrelement, das dazu ausgeführt ist, mit dem ersten Sperrelement in der verriegelten Stellung des Verriegelungsschiebers in Eingriff zu gehen, und das dazu ausgeführt ist, beim Empfang eines Entsperrsignals das erste Sperrelement freizugeben. Der Verriegelungsschieber, der die Türen in einer geschlossenen Stellung halten kann, kann auf diese Weise mit den Sperrelementen an einer Bewegung gehindert werden, wenn die elektrische Anlage im Inneren des Schaltschranks unter Spannung steht. Der Verriegelungsschieber kann im Rahmen des Schaltschranks gelagert sein und/oder kann eine längliche, flache Stange als mechanisches Grundelement aufweisen.

Die Verriegelungsvorrichtung umfasst weiter für wenigstens zwei Türen jeweils einen Türsicherungsschieber, der entlang der Türe zwischen einer entriegelten Stellung und einer verriegelten Stellung verschiebbar ist und der in einer geschlossenen Stellung der Türe mit dem Verriegelungsschieber gekoppelt ist, so dass der Verriegelungsschieber und der Türsicherungsschieber zusammen verschiebbar sind. Der Türsicherungsschieber kann in der jeweiligen Türe des Schaltschranks gelagert sein, so dass er in der Türe verschiebbar ist, aber mit der Türe mit bewegt werden kann. Wenn die Türe geschlossen wird, greifen der Türsicherungsschieber und der Verriegelungsschieber ineinander, so dass sie nur noch miteinander bewegt werden können. Der Türsicherungsschieber kann eine längliche, flache Stange als mechanisches Grundelement aufweisen. Mit anderen Worten: Der Türsicherungsschieber greift in seiner verriegelten Stellung in die jeweilige Verschlussstange der zugehörigen Türe, um ein Verschieben der jeweiligen Verschlussstange zu verhindern, so dass auf diese Weise die mindestens eine Verschlussstange die jeweilige Türe verschlossen hält, d.h. der Türsicherungsschieber verhindert in seiner verriegelten Stellung das Verschieben sämtlicher Verschlussstangen, also werden folglich auch sämtliche Türen verschlossen gehalten.

Die Verriegelungsvorrichtung umfasst weiter für wenigstens zwei Türen jeweils wenigstens eine Verschlussstange, die entlang der Türe zwischen einer entriegelten Stellung und einer verriegelten Stellung verschiebbar ist, wobei die Verschlussstange in ihrer verriegelten Stellung mit einem Rahmen des Schaltschranks in Eingriff steht. Beispielsweise kann am Rahmen ein Haken angebracht sein, der beim Schließen der Türe in eine Öffnung in der Verschlussstange geschoben wird. Beim Verschieben der Verschlussstange hintergreift dann der Haken den Rand der Öffnung, so dass die Türe bzw. die Verschlussstange am Haken gehalten wird. Die Verschlussstange kann beispielsweise ein U-förmiges Profil mit länglichen Löchern an der Basis des U aufweisen.

Der Türsicherungsschieber greift in seiner verriegelten Stellung in die Verschlussstange ein, um ein Verschieben der Verschlussstange zu verhindern. Auf diese Weise können die Verschlussstangen die jeweilige Türe verschlossen halten. Die Türsicherungsschieber verhindern ein Bewegen der Verschlussstange und werden vom Verriegelungsschieber selbst am Bewegen gehindert. Der Verriegelungsschieber wiederum wird von den beiden Verschlusselementen daran gehindert, sich zu bewegen.

Gemäß einer Ausführungsform der Erfindung ist die Verschlussstange durch Drehen eines Griffs von einem Benutzer zwischen der entriegelten Stellung und der verriegelten Stellung verschiebbar. Beispielsweise kann an dem Griff ein Zahnrad befestigt sein, das in eine Zahnstange oder eine Lochstange an der Verschlussstange eingreift.

Gemäß einer Ausführungsform der Erfindung weist die Verriegelungsvorrichtung je Türe je zwei Verschlussstangen auf, die an gegenüberliegenden Kanten der Türe mit dem Rahmen in Eingriff gehen. Lediglich eine der beiden Verschlussstangen, beispielsweise die obere, kann dabei vom Türsicherungsschieber am Verschieben gehindert werden. Die andere Verschlussstange kann indirekt über die andere Verschlussstange über eine gemeinsame Mechanik (wie etwa der Griff) am Verschieben gehindert werden.

Gemäß einer Ausführungsform der Erfindung ist die Verschlussstange parallel zu einer Schwenkachse der Türe verschiebbar. Beispielsweise kann die Verschlussstange gegenüberliegend zum Scharnier der Türe angeordnet sein.

Gemäß einer Ausführungsform der Erfindung umfasst das erste Sperrelement einen Riegel, der in dem zweiten Sperrelement aufnehmbar ist. Der Riegel kann an einer Seite des Verriegelungsschiebers angebracht sein. Das zweite, elektrisch betätigbare Sperrelement kann gegenüberliegend am Rahmen des Schaltschranks befestigt sein.

Gemäß einer Ausführungsform der Erfindung ist der Verriegelungsschieber in einer Richtung quer zur Schwenkachse der Türen verschiebbar. Genauso kann der Türsicherungsschieber in einer Richtung quer zur Schwenkachse der Türen verschiebbar sein.

Gemäß einer Ausführungsform der Erfindung weist wenigstens einer der Türsicherungsschieber einen Griff auf, über den ein Benutzer den Türsicherungsschieber verschieben kann. Beispielsweise kann die zugehörige Türe ein Loch im Türblatt aufweisen, durch das der Griff herausragt. Wenn alle Türen geschlossen sind, kann dann mit dem Griff der Türsicherungsschieber zusammen mit dem Verriegelungsschieber von der geschlossenen Stellung in die geöffnete Stellung bewegt werden (wenn dies durch die Verschlusselemente zugelassen wird). Bei dieser Bewegung werden gleichzeitig die Türsicherungsschieber der anderen Türen in die geöffnete Stellung bewegt. Auf diese Weise werden alle Verschlussstangen freigegeben. Somit können dann alle Türen geöffnet werden.

Gemäß einer Ausführungsform der Erfindung umfasst der Türsicherungsschieber eine Mitnehmerklammer, die dazu ausgeführt ist, bei geschlossener Stellung der Tür in einen am Verriegelungsschieber befestigten Mitnehmerbolzen einzurasten. Eine Möglichkeit, mit der der Türsicherungsschieber bei geschlossener Türe am Verriegelungsschieber fixiert werden kann, ist eine am Türsicherungsschieber befestigte Klammer, die den Mitnehmerbolzen umgreift, wenn die Türe geschlossen wird.

Gemäß einer Ausführungsform der Erfindung umfasst die Verriegelungsvorrichtung weiter für wenigstens zwei Türen jeweils einen mit dem Verriegelungsschieber verbundenen Sperrhaken, der dazu ausgeführt ist, den Verriegelungsschieber in der entriegelten Stellung zu halten, wenn die Türe geöffnet ist, so dass erst, wenn mehrere oder alle Türen geschlossen sind, der Verriegelungsschieber in die verriegelte Stellung schiebbar ist. Wenn alle Türen einen derartigen Sperrhaken aufweisen, kann der Verriegelungsschieber erst dann in die geschlossene bzw. verriegelte Stellung geschoben werden, wenn alle Türen geschlossen sind.

Der Sperrhaken kann um eine Achse parallel zu einer Schwenkachse der Türe schwenkbar sein. Beispielsweise kann der Sperrhaken an einer Seite des Verriegelungsschiebers angebracht sein und dazu ausgeführt sein, einen Sperrbolzen zu umgreifen, der am Rahmen des Schaltschranks angebracht ist.

Gemäß einer Ausführungsform der Erfindung wird der Sperrhaken mittels einer Feder in Richtung eines Sperrbolzens gedrückt, um den Verriegelungsschieber in der geöffneten Stellung zu halten. Der Sperrbolzen kann am Rahmen des Schaltschranks befestigt sein. Durch Verschieben der Verriegelungsschieber in die geöffnete Stellung gleitet der Sperrhaken über den Sperrbolzen und die Feder verhindert, dass sich der Sperrhaken wieder selbstständig öffnet.

Gemäß einer Ausführungsform der Erfindung ist der Türsicherungsschieber für die jeweilige Türe dazu ausgeführt, den Sperrhaken beim Schließen der Türe zu entriegeln. Beispielsweise kann die Mitnehmerklammer, die auch dazu dient, den Türsicherungsschieber am Verriegelungsschieber zu sichern, wenn die Türe geschlossen wird, auch dazu verwendet werden, den Sperrhaken (entgegen der Kraftwirkung der Feder) vom Sperrbolzen zu lösen.

Ein weiterer Aspekt der Erfindung betrifft einen Schaltschrank mit einer derartigen Verriegelungsvorrichtung.

Gemäß einer Ausführungsform der Erfindung umfasst der Schaltschrank einen Rahmen, in dem eine Mehrzahl von Türen schwenkbar gelagert ist, und eine Verriegelungsvorrichtung, so wie sie obenstehend und untenstehend beschrieben ist. In der Regel wird das Innere des Schaltschranks von Abdeckplatten an den Seiten und an der Decke des Schaltschranks, die am Rahmen befestigt sind, umschlossen sein.

Der Verriegelungsschieber kann relativ zum Rahmen verschiebbar sein. Beispielsweise ist der Verriegelungsschieber am Rahmen gelagert.

Die Verriegelungsvorrichtung kann dazu dienen, wenigstens zwei (und vorzugsweise alle) Türen des Schaltschranks zu verschließen, wenn eine elektrische Anlage im Inneren des Schaltschranks im Betrieb ist. Dabei kann das elektrisch betätigbare Sperrelement so eingestellt sein, dass es während des Betriebes der elektrischen Anlage, wenn diese unter Spannung steht, den Verriegelungsschieber festhält, so dass die Türen nicht geöffnet werden können.

Wenigstens zwei oder auch alle Türen des Schaltschranks umfassen dazu jeweils einen Türsicherungsschieber und eine Verschlussstange, die relativ zu der jeweiligen Türe verschiebbar sind und mit der Türe schwenkbar sind. Der Verriegelungsschieber hindert bei verschlossenen Türen, dass die Türsicherungsschieber verschoben werden können. Die Türsicherungsschieber hindern wiederum ein Verschieben der Verschlussstangen, die die Türen geschlossen halten.

### KURZE BESCHREIBUNG DER FIGUREN

Im Folgenden werden Ausführungsbeispiele der Erfindung mit Bezug auf die beiliegenden Figuren detailliert beschrieben.
Fig. 1 zeigt eine perspektivische Ansicht eines Schaltschranks gemäß einer Ausführungsform der Erfindung.
Fig. 2 zeigt den Schaltschrank aus der Fig. 1 von vorne.
Fig. 3 zeigt eine perspektivische Ansicht eines Türschließers des Schaltschranks aus der Fig. 1.
Fig. 4 zeigt eine perspektivische Ansicht einer Verriegelungsvorrichtung gemäß einer Ausführungsform der Erfindung.
Fig. 5 zeigt eine perspektivische Ansicht der Verriegelungsvorrichtung aus der Fig. 4 im verriegelten Zustand.
Fig. 6 zeigt eine perspektivische Ansicht einer Verschlussstange des Schaltschranks aus der Fig. 1.
Fig. 7 zeigt eine perspektivische Ansicht eines Rahmenelements des Schaltschranks aus der Fig. 1.
Fig. 8 zeigt eine perspektivische Ansicht einer Verschlussstange des Schaltschranks aus der Fig. 1.

Die in den Figuren verwendeten Bezugszeichen und ihre Bedeutung sind in zusammenfassender Form in der Liste der Bezugszeichen aufgeführt. Grundsätzlich sind identische oder ähnliche Teile mit den gleichen Bezugszeichen versehen.

### DETAILLIERTE BESCHREIBUNG VON AUSFÜHRUNGSBEISPIELEN

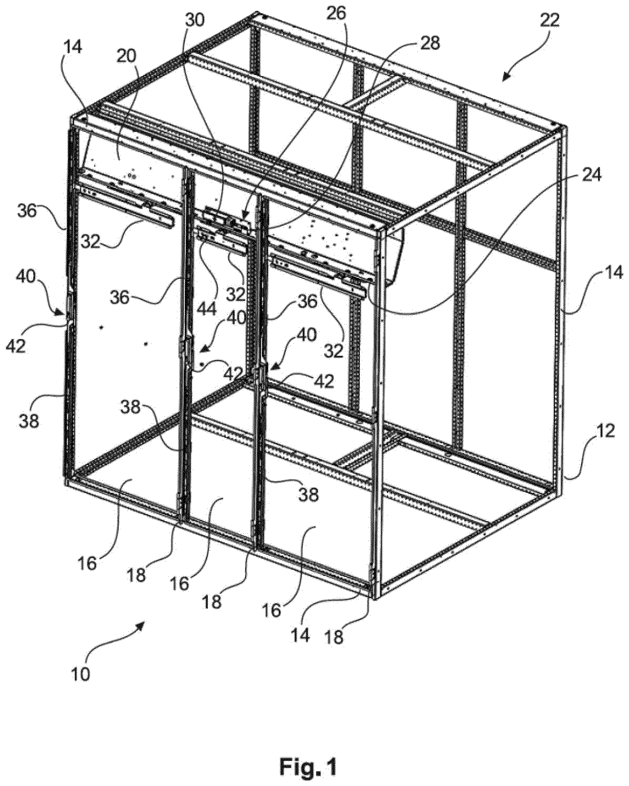

Fig. 1 und 2 zeigen einen Schaltschrank 10, der als tragende Struktur einen Rahmen 12 umfasst, der aus Rahmenelementen 14 aufgebaut ist, die unter anderem an den Kanten des Schaltschranks 10 angeordnet sind. An den Seiten, der Rückseite und/oder der Oberseite des Schaltschranks sind (in den Fig. 1 und 2 nicht gezeigte) Abdeckplatten am Rahmen 12 befestigt, um eine elektrische Einrichtung im Inneren des Schaltschranks 10 von der Umgebung abzuschließen.

An der Vorderseite des Schaltschranks 10 befinden sich Türen 16, die jeweils um eine vertikale Achse 18 schwenkbar sind. Hinten den Türen befindet sich an der Oberseite des Schaltschranks 10 ein Kabelkanal 20, der am Rahmen 12 befestigt ist.

Auch an den Türen 16 sind Abdeckplatten befestigt, die in den Fig. 1 und 2 weggelassen wurden, um eine Verriegelungsvorrichtung 22 des Schaltschranks 10 zu zeigen.

Die Verriegelungsvorrichtung 22 umfasst einen Verriegelungsschieber 24 in der Form einer Schiene, der unterhalb des Kabelkanals 20 in einer horizontalen Richtung zwischen einer entriegelten Stellung und einer verriegelten Stellung verschiebbar ist.

An dem Verriegelungsschieber 24 ist ein erstes Sperrelement 26 befestigt, das einen Riegel 28 umfasst, der in ein zweites Sperrelement 30 eingeschoben werden kann, wenn der Verriegelungsschieber 24 (wie beispielsweise hier gezeigt nach links) in die verriegelte Stellung bewegt wird.

Das zweite Sperrelement 30 kann beispielsweise ein elektrisch betätigbarer Aktuator sein, der beim Empfang eines Entsperrsignals das erste Sperrelement 26 freigibt.

Jede der Türen 16 umfasst einen Türsicherungsschieber 32, der auch die Form einer Schiene aufweisen kann und der entlang der jeweiligen Türe 16 in horizontaler Richtung zwischen einer entriegelten Stellung und einer verriegelten Stellung verschiebbar ist. Der Türsicherungsschieber 32 ist dabei derart an der Türe befestigt, dass er bezüglich der Türe verschoben und mit der Türe 16 zusammen um die Schwenkachse 18 geschwenkt werden kann. Wenn die Türen 16 geschlossen sind, wie es in den Fig. 1 und 2 gezeigt ist, ist der jeweilige Türsicherungsschieber 32 mit dem Verriegelungsschieber 24 gekoppelt, so dass der Verriegelungsschieber 24 und der Türsicherungsschieber 32 zusammen horizontal verschiebbar sind.

Jede der Türen 16 umfasst eine obere Verschlussstange 36 und eine untere Verschlussstange 38, die in einer vertikalen Richtung entlang der Türe 16 zwischen einer entriegelten Stellung und einer verriegelten Stellung verschiebbar sind. In ihrer verriegelten Stellung stehen die Verschlussstangen 36, 38 mit dem Rahmen 12 im Eingriff, so dass sich die Türen 16 nicht öffnen lassen.

Jede der Türen 16 umfasst weiter einen Türschließer 40, der beispielsweise ein Schloss und einen Griff 42 aufweisen kann, mit dem eine Person, beispielsweise ein Wartungsmechaniker, die jeweilige Türe 16 öffnen kann und durch Drehen des Griffes die Tür 16 entriegeln kann. Über eine Mechanik ist der Griff 42 mit den beiden Verschlussstangen 36, 38 verbunden, so dass bei Drehen des Griffs 42 die Verschlussstangen 36, 38 nach oben und unten bewegt werden.

Dies ist jedoch nur möglich, wenn die Verschlussstangen 36 vom Türsicherungsschieber 32 der jeweiligen Türe 16 nicht daran gehindert werden, da der Türsicherungsschieber 32 der Türe in seiner verriegelten Stellung in die Verschlussstange 36 (der gleichen Türe 16) eingreift, um ein Verschieben der Verschlussstangen 36, 38 zu verhindern.

Befindet sich der Schaltschrank im verriegelten Zustand, hindern die Verschlussstangen 36, 38 die jeweilige Türe 16 am Öffnen, und der jeweilige Türsicherungsschieber 32 hindert die Verschlussstange 36 am Verschieben. Da die Türen 16 geschlossen sind, sind die Türsicherungsschieber 32 mit dem Verriegelungsschieber 24 gekoppelt und werden somit von dem Verriegelungsschieber 24 am Verschieben gehindert. Der Verriegelungsschieber 24 wird über das erste Sperrelement 26 und das zweite Sperrelement 30 am Verschieben gehindert.

Wenn das zweite Sperrelement 30 ein Entsperrsignal empfängt (beispielsweise, wenn die elektrische Anlage im Inneren des Schaltschranks 10 nicht mehr unter Spannung steht), entriegelt sich das zweite Sperrelement 30 und gibt das erste Sperrelement 26 frei.

Ein Benutzer kann dann einen der Türsicherungsschieber 32 zusammen mit dem Verriegelungsschieber 24 in die entriegelte Stellung schieben (hier nach rechts). Dazu kann einer der Türsicherungsschieber 32 einen Griff 44 aufweisen, der durch eine Öffnung in einer Abdeckplatte der betreffenden Türe 16 nach außen ragt. Da die anderen Türsicherungsschieber 32 auch mit dem Verriegelungsschieber 24 gekoppelt sind, werden auch diese in die entriegelte Stellung geschoben und geben die Verschlussstange 36 frei.

Der Benutzer kann durch Drehen des Griffs 42 einer Türe die Verschlussstangen 36, 38 in die entriegelte Stellung bewegen und die jeweilige Türe 16 öffnen.

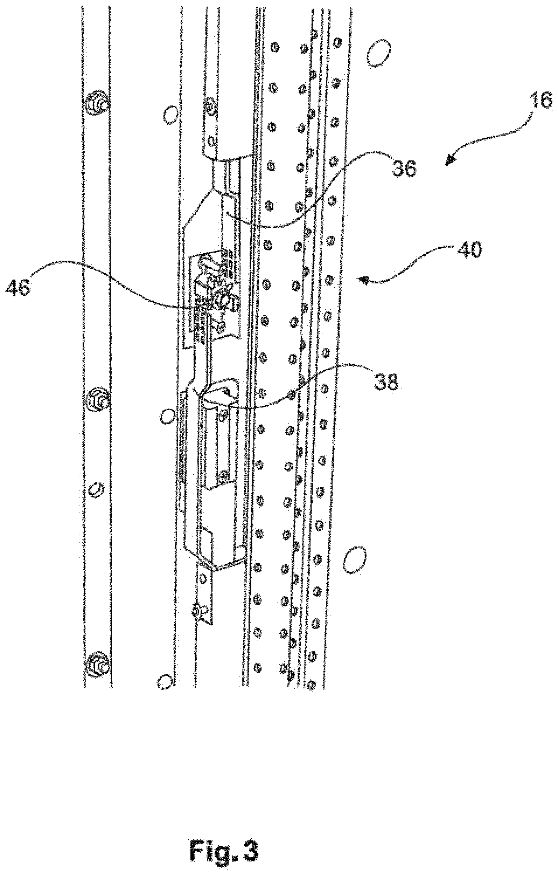

Die Fig. 3 zeigt einen Ausschnitt des Schaltschranks aus den Fig. 1 und 2, der den Türschließer 40 und einen Teil der Verschlussstangen 36, 38 zeigt. Der Griff 42 ist mit einem Zahnrad 46 verbunden, das in Löcher in den Verschlussstangen 36, 38 eingreift. Wird der Griff 42 gedreht, dreht sich das Zahnrad 46 und verschiebt die Verschlussstangen 36, 38 entgegengesetzt zueinander nach oben bzw. unten. Durch das Zahnrad sind die beiden Verschlussstangen 36, 38 derart miteinander gekoppelt, dass die verriegelte Verschlussstange 36 auch die Verschlussstange 38 am Bewegen hindert.

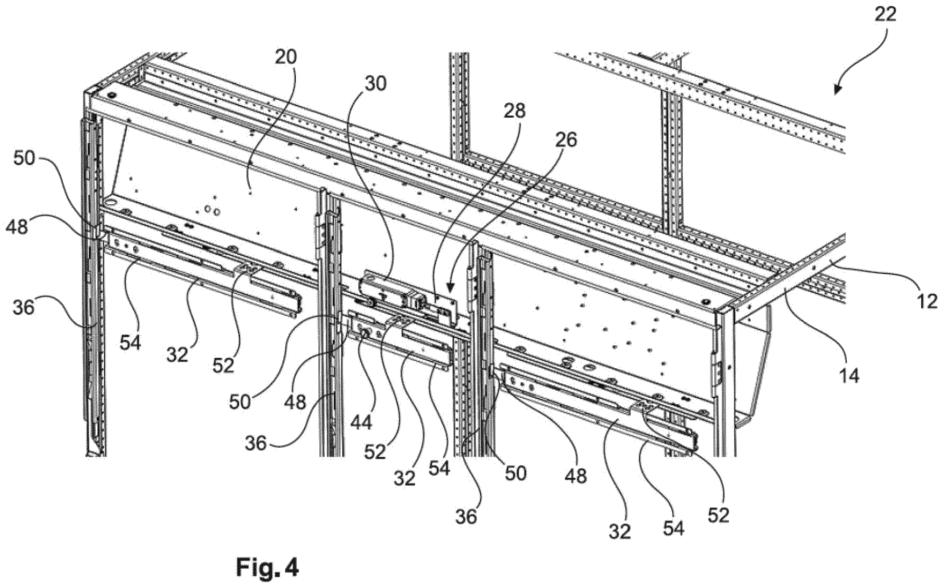

Die Fig. 4 zeigt einen Teil der Verriegelungsvorrichtung 22 des Schaltschranks 10 vergrößert. Aus der Fig. 4, die den Verriegelungsschieber 24 und die Türsicherungsschieber 32 in der entriegelten Stellung zeigt, geht hervor, dass Türsicherungsschieber 32 als längliche Schiene ausgebildet sind, die an einem Ende einen Riegel 48 aufweisen, der in eine Öffnung 50 in der jeweiligen Verschlussstange 36 eingreifen kann. Weiter weist der Türsicherungsschieber 32 eine Mitnehmerklammer 52 auf, die seitlich von dem Türsicherungsschieber 32 absteht und in den Verriegelungsschieber 24 eingreifen kann, wenn die Türe 16 geschlossen ist. An der Türe 16 ist auch eine Führungsschiene 54 befestigt, in der der Türsicherungsschieber 32 gelagert ist.

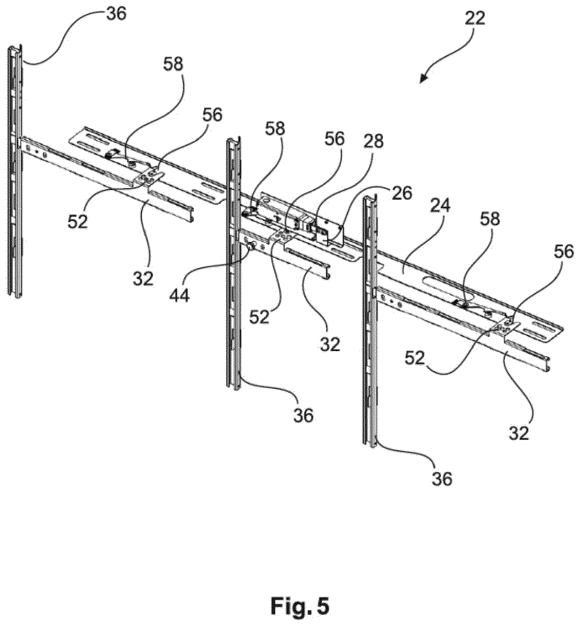

Die Fig. 5 zeigt einen Teil der Verriegelungsvorrichtung 22 analog der Fig. 4 mit dem Verriegelungsschieber 24 und den Türsicherungsschieber 32 in der verriegelten Stellung.

Wie in der Fig. 5 zu erkennen ist, umgreift die Mitnehmerklammer 52 jedes Türsicherungsschiebers 32 einen jeweiligen Mitnehmerbolzen 56, der an dem Verriegelungsschieber 24 befestigt ist. Auf diese Weise kann der Türsicherungsschieber 32 mit dem Verriegelungsschieber 24 bei geschlossener Türe 16 gekoppelt werden.

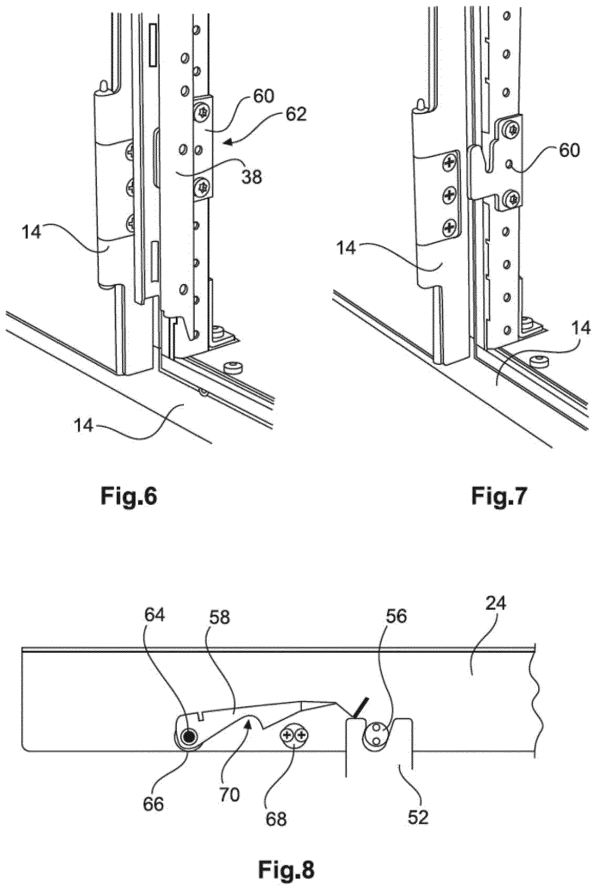

Weiter ist in der Fig. 5 je Türsicherungsschieber 32 ein Sperrhaken 58 zu erkennen, der in der Fig. 8 genauer beschrieben wird.

Die Fig. 6 und 7 zeigen einen Ausschnitt aus dem Schaltschrank 10, der zeigt, wie eine Verschlussstange (hier 38) mit dem Rahmen 12 in Eingriff gebracht werden kann. Eine analoge (gespiegelte) Anordnung kann auch mit der Verschlussstange 36 gebildet werden. Am Rahmen 12 ist ein Haken 60 angebracht, der beim Schließen der Türe 16 in einer entsprechenden Öffnung 62 in der Verschlussstange 38 aufgenommen wird. Bewegt sich die Verschlussstange 38 dann nach unten, hintergreift der Haken 60 den Rand der Öffnung und hindert die Türe 16 am Öffnen.

Die Fig. 8 zeigt einen Abschnitt des Verriegelungsschiebers 24 mit einem Sperrhaken 58. Der Sperrhaken 58 ist um eine Achse 64 drehbar und wird von einer Feder 66 in Richtung eines Bolzens 68 gedrückt, der am Rahmen 12 bzw. Kabelkanal 20 befestigt ist.

Ist die jeweilige Türe geöffnet, befindet sich der Verriegelungsschieber 24 in der entriegelten Stellung und eine Vertiefung 70 des Sperrhakens 58 liegt auf dem Bolzens 68 und verhindert, dass der Verriegelungsschieber 24 verschoben wird.

Durch Schließen der Türe 16 umgreift die Mitnehmerklammer 52 nicht nur den Mitnehmerbolzen 56, sondern drückt auch den Sperrhaken vom Bolzen 68 weg. Erst wenn alle Türen 16 geschlossen sind, kann der Verriegelungsschieber 24 wieder in die verriegelte Stellung geschoben werden.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### LISTE DER BEZUGSZEICHEN

- 10: Schaltschrank
- 12: Rahmen
- 14: Rahmenelement
- 16: Tür
- 18: Achse
- 20: Kabelkanal
- 22: Verriegelungsvorrichtung
- 24: Verriegelungsschieber
- 26: erstes Sperrelement
- 28: Riegel
- 30: zweites Sperrelement
- 32: Türsicherungsschieber
- 36, 38: Verschlussstange
- 40: Türschließer
- 42, 44: Griff
- 46: Zahnrad
- 48: Riegel
- 50: Öffnung
- 52: Mitnehmerklammer
- 54: Führungsschiene
- 56: Mitnehmerbolzen
- 58: Sperrhaken
- 60: Haken
- 62: Öffnung
- 64: Achse
- 66: Feder
- 68: Bolzen
- 70: Vertiefung

## Patentansprüche

1. Verriegelungsvorrichtung (22) für einen Schaltschrank (10) mit einer Mehrzahl von Türen (16), die Verriegelungsvorrichtung (22) umfassend:
einen Verriegelungsschieber (24), der zwischen einer entriegelten Stellung und einer verriegelten Stellung verschiebbar ist;
ein mit dem Verriegelungsschieber (24) verbundenes erstes Sperrelement (26); ein elektrisch betätigbares zweites Sperrelement (30), das dazu ausgeführt ist, mit dem ersten Sperrelement (26) in der verriegelten Stellung des Verriegelungsschiebers (24) in Eingriff zu gehen, und das dazu ausgeführt ist, beim Empfang eines Entsperrsignals das erste Sperrelement (26) freizugeben,
für wenigstens zwei Türen (16) jeweils einen Türsicherungsschieber (32), der entlang der jeweiligen Türe (16) zwischen einer entriegelten Stellung und einer verriegelten Stellung verschiebbar ist und der in einer geschlossenen Stellung der Türe (16) mit dem Verriegelungsschieber (24) gekoppelt ist, so dass der Verriegelungsschieber (24) und der Türsicherungsschieber (32) zusammen verschiebbar sind,
**dadurch gekennzeichnet, dass** für wenigstens zwei Türen (16) jeweils wenigstens eine Verschlussstange (36), die entlang der jeweiligen Türe (16) zwischen einer entriegelten Stellung und einer verriegelten Stellung verschiebbar ist, wobei die jeweilige Verschlussstange (36) in ihrer verriegelten Stellung mit einem Rahmen (12) des Schaltschranks (10) in Eingriff steht,
wobei der Türsicherungsschieber (32) in seiner verriegelten Stellung in die jeweilige Verschlussstange (36) eingreift, um ein Verschieben der jeweiligen Verschlussstange (36) zu verhindern.

2. Verriegelungsvorrichtung (22) nach Anspruch 1,
wobei die Verschlussstange (36) durch Drehen eines Griffs (42) von einem Benutzer zwischen der entriegelten Stellung und der verriegelten Stellung verschiebbar ist.

3. Verriegelungsvorrichtung (22) nach Anspruch 1 oder 2,
wobei die Verriegelungsvorrichtung (22) je Türe (16) je zwei Verschlussstangen (36, 38) aufweist, die an gegenüberliegenden Kanten der Türe (16) mit dem Rahmen (12) in Eingriff gehen.

4. Verriegelungsvorrichtung (22) nach einem der vorhergehenden Ansprüche,
wobei die Verschlussstange (36) parallel zu einer Schwenkachse (18) der Türe (16) verschiebbar ist.

5. Verriegelungsvorrichtung (22) nach einem der vorhergehenden Ansprüche, wobei das erste Sperrelement (26) einen Riegel (28) umfasst, der in dem zweiten Sperrelement (30) aufnehmbar ist.

6. Verriegelungsvorrichtung (22) nach einem der vorhergehenden Ansprüche,
wobei der Verriegelungsschieber (24) in einer Richtung quer zur Schwenkachse (18) der Türen (16) verschiebbar ist.

7. Verriegelungsvorrichtung (22) nach einem der vorhergehenden Ansprüche,
wobei der Türsicherungsschieber (32) in einer Richtung quer zur Schwenkachse (18) der Türen (16) verschiebbar ist.

8. Verriegelungsvorrichtung (22) nach einem der vorhergehenden Ansprüche,
wobei wenigstens einer der Türsicherungsschieber (32) einen Griff (44) aufweist, über den ein Benutzer den Türsicherungsschieber (32) verschieben kann.

9. Verriegelungsvorrichtung (22) nach einem der vorhergehenden Ansprüche,
wobei der Türsicherungsschieber (32) eine Mitnehmerklammer (52) umfasst, die dazu ausgeführt ist, bei geschlossener Stellung der Tür (16) in einen am Verriegelungsschieber (24) befestigten Mitnehmerbolzen (56) einzurasten.

10. Verriegelungsvorrichtung (22) nach einem der vorhergehenden Ansprüche, weiter umfassend:
für wenigstens zwei Türen (16) jeweils einen mit dem Verriegelungsschieber (24) verbundenen Sperrhaken (58), der dazu ausgeführt ist, den Verriegelungsschieber (24) in der entriegelten Stellung zu halten, wenn die Türe (16) geöffnet ist, so dass erst, wenn mehrere Türen (16) geschlossen sind, der Verriegelungsschieber (24) in die verriegelte Stellung schiebbar ist.

11. Verriegelungsvorrichtung (22) nach Anspruch 10,
wobei der Sperrhaken (58) um eine Achse (64) parallel zu einer Schwenkachse (18) der Türe (16) schwenkbar ist.

12. Verriegelungsvorrichtung (22) nach Anspruch 10 oder 11,
wobei der Sperrhaken (58) mittels einer Feder (66) in Richtung eines Sperrbolzens (68) gedrückt wird, um den Verriegelungsschieber (24) in der geöffneten Stellung zu halten;

13. Verriegelungsvorrichtung (22) nach einem der Ansprüche 10 bis 12,
wobei der Türsicherungsschieber (32) für die jeweilige Türe (16) dazu ausgeführt ist, den Sperrhaken (58) beim Schließen der Türe (16) zu entriegeln.

14. Schaltschrank (10), umfassend:
einen Rahmen (12), in dem eine Mehrzahl von Türen (16) schwenkbar gelagert sind;
eine Verriegelungsvorrichtung (22) nach einem der Ansprüche 1 bis 13;
wobei der Verriegelungsschieber (24) relativ zu dem Rahmen (12) verschiebbar ist;
wobei wenigstens zwei Türen (16) jeweils einen Türsicherungsschieber (32) und eine Verschlussstange (36) umfassen, die relativ zu der jeweiligen Türe (16) verschiebbar sind und mit der Türe (16) schwenkbar sind.

## Claims

1. Locking apparatus (22) for a switchgear cabinet (10) having a plurality of doors (16), the locking apparatus (22) including:
a locking slide (24) which is displaceable between an unlocked position and a locked position;
a first blocking element (26) connected to the locking slide (24);
an electrically actuatable second blocking element (30) which is designed to enter into engagement with the first blocking element (26) in the locked position of the locking slide (24) and which is designed to release the first blocking element (26) upon receiving an unblocking signal,
for at least two doors (16), in each instance a door-securing slide (32) which is displaceable along the respective door (16) between an unlocked position and a locked position and which in a closed position of the door (16) has been coupled with the locking slide (24), so that the locking slide (24) and the door-securing slide (32) are displaceable together,
**characterized in that**, for at least two doors (16), in each instance at least one closure rod (36) which is displaceable along the respective door (16) between an unlocked position and a locked position, wherein the respective closure rod (36) in its locked position is in engagement with a frame (12) of the switchgear cabinet (10),
wherein the door-securing slide (32) in its locked position engages with the respective closure rod (36) in order to prevent a displacement of the respective closure rod (36).

2. Locking apparatus (22) according to Claim 1, wherein the closure rod (36) is displaceable by a user between the unlocked position and the locked position by a handle (42) being turned.

3. Locking apparatus (22) according to Claim 1 or 2,
wherein the locking apparatus (22) exhibits, for each door (16), two closure rods (36, 38) which enter into engagement with the frame (12) on opposite edges of the door (16).

4. Locking apparatus (22) according to one of the preceding claims,
wherein the closure rod (36) is displaceable parallel to a swivel axis (18) of the door (16).

5. Locking apparatus (22) according to one of the preceding claims,
wherein the first blocking element (26) includes a latch (28) which is capable of being received in the second blocking element (30).

6. Locking apparatus (22) according to one of the preceding claims,
wherein the locking slide (24) is displaceable in a direction at right angles to the swivel axis (18) of the doors (16).

7. Locking apparatus (22) according to one of the preceding claims,
wherein the door-securing slide (32) is displaceable in a direction at right angles to the swivel axis (18) of the doors (16).

8. Locking apparatus (22) according to one of the preceding claims,
wherein at least one of the door-securing slides (32) exhibits a handle (44) via which a user can displace the door-securing slide (32).

9. Locking apparatus (22) according to one of the preceding claims,
wherein the door-securing slide (32) includes a driving clasp (52) which is designed to latch, in the closed position of the door (16), into a driving pin (56) fastened to the locking slide (24).

10. Locking apparatus (22) according to one of the preceding claims, further including:
for at least two doors (16), in each instance a blocking hook (58) connected to the locking slide (24), which is designed to hold the locking slide (24) in the unlocked position when the door (16) is open, so that only when a plurality of doors (16) are closed can the locking slide (24) be pushed into the locked position.

11. Locking apparatus (22) according to Claim 10,
wherein the blocking hook (58) is capable of swiveling about an axis (64) parallel to a swivel axis (18) of the door (16).

12. Locking apparatus (22) according to Claim 10 or 11,
wherein the blocking hook (58) is pushed by means of a spring (66) in the direction of a blocking pin (68) in order to hold the locking slide (24) in the open position.

13. Locking apparatus (22) according to one of Claims 10 to 12,
wherein the door-securing slide (32) for the respective door (16) is designed to unlock the blocking hook (58) when the door (16) is being closed.

14. Switchgear cabinet (10) including:
a frame (12) in which a plurality of doors (16) have been mounted so as to be capable of swiveling;
a locking apparatus (22) according to one of Claims 1 to 13;
wherein the locking slide (24) is displaceable relative to the frame (12);
wherein at least two doors (16) include, in each instance, a door-securing slide (32) and a closure rod (36) which are displaceable relative to the respective door (16) and are capable of swiveling with the door (16).

## Revendications

1. Dispositif de verrouillage (22) pour une armoire de commande (10) dotée d'une multiplicité de portes (16), le dispositif de verrouillage (22) comprenant:
un coulisseau de verrouillage (24), qui est déplaçable entre une position déverrouillée et une position verrouillée;
un premier élément d'arrêt (26) relié au coulisseau de verrouillage (24);
un deuxième élément d'arrêt (30) pouvant être actionné électriquement,
qui est configuré pour venir en prise avec le premier élément d'arrêt (26) dans la position verrouillée du coulisseau de verrouillage (24), et qui est configuré pour libérer le premier élément d'arrêt (26) lors de la réception d'un signal de déverrouillage,
pour au moins deux portes (16), chaque fois un coulisseau de blocage de porte (32), qui est déplaçable le long de la porte respective (16) entre une position déverrouillée et une position verrouillée et qui est couplé au coulisseau de verrouillage (24) dans une position fermée de la porte (16), de telle manière que le coulisseau de verrouillage (24) et le coulisseau de blocage de porte (32) soient déplaçables ensemble,
**caractérisé en ce que** pour au moins deux portes (16) chaque fois au moins une tige de fermeture (36), qui est déplaçable le long de la porte respective (16) entre une position déverrouillée et une position verrouillée, dans lequel la tige de fermeture respective (36) est en prise dans sa position verrouillée avec un châssis (12) de l'armoire de commande (10), dans lequel le coulisseau de blocage de porte (32) s'engage dans sa position verrouillée dans la tige de fermeture respective (36) afin d'empêcher un déplacement de la tige de fermeture respective (36).

2. Dispositif de verrouillage (22) selon la revendication 1, dans lequel la tige de fermeture (36) est déplaçable entre la position déverrouillée et la position verrouillée par un utilisateur par la rotation d'une poignée (42).

3. Dispositif de verrouillage (22) selon la revendication 1 ou 2, dans lequel le dispositif de verrouillage (22) présente par porte (16) chaque fois deux tiges de fermeture (36, 38), qui viennent en prise avec le châssis (12) sur des côtés opposés de la porte (16).

4. Dispositif de verrouillage (22) selon l'une quelconque des revendications précédentes, dans lequel la tige de fermeture (36) est déplaçable parallèlement à un axe de pivotement (18) de la porte (16).

5. Dispositif de verrouillage (22) selon l'une quelconque des revendications précédentes, dans lequel le premier élément d'arrêt (26) comprend un verrou (28), qui peut être logé dans le deuxième élément d'arrêt (30).

6. Dispositif de verrouillage (22) selon l'une quelconque des revendications précédentes, dans lequel le coulisseau de verrouillage (24) est déplaçable dans une direction transversale à l'axe de pivotement (18) des portes (16).

7. Dispositif de verrouillage (22) selon l'une quelconque des revendications précédentes, dans lequel le coulisseau de blocage de porte (32) est déplaçable dans une direction transversale à l'axe de pivotement (18) des portes (16).

8. Dispositif de verrouillage (22) selon l'une quelconque des revendications précédentes, dans lequel au moins un des coulisseaux de blocage de porte (32) présente une poignée (44), au moyen de laquelle un utilisateur peut déplacer le coulisseau de blocage de porte (32).

9. Dispositif de verrouillage (22) selon l'une quelconque des revendications précédentes, dans lequel le coulisseau de blocage de porte (32) comprend une attache d'entraînement, qui est configurée de façon à s'encliqueter, dans la position fermée de la porte (16), dans un axe d'entraînement (56) fixé au coulisseau de verrouillage (24).

10. Dispositif de verrouillage (22) selon l'une quelconque des revendications précédentes, comprenant en outre:
pour au moins deux portes (16) chaque fois un crochet d'arrêt (58) relié au coulisseau de verrouillage (24), qui est configuré de façon à maintenir le coulisseau de verrouillage (24) dans la position déverrouillée, lorsque la porte (16) est ouverte, de telle manière que le coulisseau de verrouillage (24) ne soit déplaçable dans la position verrouillée que lorsque plusieurs portes (16) sont fermées.

11. Dispositif de verrouillage (22) selon la revendication 10, dans lequel le crochet d'arrêt (58) peut pivoter autour d'un axe (64) parallèle à un axe de pivotement (18) de la porte (16).

12. Dispositif de verrouillage (22) selon la revendication 10 ou 11, dans lequel le crochet d'arrêt (58) est poussé au moyen d'un ressort (66) en direction d'un axe d'arrêt (68), afin de maintenir le coulisseau de verrouillage (24) dans la position ouverte.

13. Dispositif de verrouillage (22) selon l'une quelconque des revendications 10 à 12, dans lequel le coulisseau de blocage de porte (32) pour la porte respective (16) est configuré de façon à déverrouiller le crochet d'arrêt (58) lors de la fermeture de la porte (16).

14. Armoire de commande (10), comprenant:
un châssis (12), dans lequel une multiplicité de portes (16) sont montées de façon pivotante;
un dispositif de verrouillage (22) selon l'une quelconque des revendications 1 à 13;
dans lequel le coulisseau de verrouillage (24) est déplaçable par rapport au châssis (12);
dans lequel au moins deux portes (16) comprennent respectivement un coulisseau de blocage de porte (32) et une tige de fermeture (36), qui sont déplaçables par rapport à la porte respective (16) et qui peuvent pivoter avec la porte (16).
